# EUROPÄISCHE PATENTSCHRIFT

(11) **EP 1 434 952 B1**
(45) Veröffentlichungstag und Bekanntmachung des Hinweises auf die Patenterteilung: **17.05.2006**
(21) Anmeldenummer: 02801279.7
(22) Anmeldetag: 01.10.2002
(51) Int. Cl.: F16F 1/02

(54) **VERFAHREN ZUR HERSTELLUNG EINER ROHRFEDER**
METHOD FOR PRODUCING A TUBULAR SPRING
PROCEDE DE FABRICATION D'UN RESSORT TUBULAIRE

(30) Priorität: 09.10.2001 DE 10149746
(43) Veröffentlichungstag der Anmeldung: 07.07.2004
(73) Patentinhaber: SIEMENS AKTIENGESELLSCHAFT, 80333 München (DE)
(72) Erfinder: JOVOVIC, Dejan, 93049 Regensburg (DE); LEWENTZ, Günter, 93055 Regensburg (DE); VOIGT, Andreas, 93055 Regensburg (DE); ZUMSTRULL, Claus, 93128 Regenstauf (DE)
(86) Internationale Anmeldenummer: PCT/DE2002/003718
(87) Internationale Veröffentlichungsnummer: WO 2003/033933

(56) Entgegenhaltungen:
- EP-A- 0 514 825
- WO-A-00/08353
- WO-A-99/08330
- WO-A-02/052669
- US-A- 4 826 143
- US-A- 4 919 403

## Beschreibung

Die Erfindung betrifft ein Verfahren zur Herstellung einer Rohrfeder, insbesondere für eine Aktoreinheit eines Kraftstoffinjektors.

Kraftstoffeinspritzsysteme der neuen Generation weisen Piezoaktorelemente als Schalt- und Stellglieder auf. Diese sog. Piezostacks, die aus aufeinander gestapelten Piezoeinheiten bestehen, sind aus Gründen der Dauerhaltbarkeit elastisch vorgespannt. Die hierfür verwendeten Vorspannelemente müssen sehr hohe Vorspannkräfte bei geringem Bauvolumen aufbringen. Sie sollen zudem eine relativ geringe Steifigkeit sowie ein einfaches und robustes Design aufweisen. Weiterhin ist eine Dauerhaltbarkeit bei hochdynamischer Belastung gefordert.

Aus der DE 38 44 134 Al ist ein Einspritzventil mit einem piezoelektrischen Aktor bekannt. Der Aktor ist in einer zylindrischen Rohrfeder angeordnet und wird von dieser gegen das Gehäuse des Einspritzventils vorgespannt. Bei diesem Aufbau der Aktoreinheit hängt jedoch die Vorspannung des piezoelektrischen Aktors stark von den Fertigungstoleranzen des Gehäuses des Einspritzventils ab. Der Einbau der Aktoreinheit ist zudem aufwendig und erfordert einen hohen Wartungsaufwand, da bei jedem Ein- und Ausbau die Vorspannung auf den piezoelektrischen Aktor durch die Rohrfeder neu eingestellt werden muss. Darüber hinaus besteht bei den verwendeten Rohrfedern auch das Problem, dass zur Erreichung einer ausreichenden Elastizität der Längsbewegung des piezoelektrischen Aktors die Rohrfeder extrem dünnwandig ausgeführt werden muss, was deren Festigkeit und die Lebensdauer der Aktoreinheit beeinträchtigt.

Eine Rohrfeder zur Vorspannung eines piezoelektrischen Aktors eines Kraftstoffeinspritzventils ist zudem aus der WO 00/08353, bzw. deren Prioritätsschrift DE 198 35 628 A1 bekannt. Diese Rohrfeder besteht aus einem dünnwandigen Hohlzylinder, in den eine Vielzahl von knochenförmig ausgebildeten Ausnehmungen eingebracht sind. Diese Ausnehmungen bewirken eine gewünschte Längselastizität der Rohrfeder. Diese bekannte Rohrfeder erfordert eine relativ aufwendige Fertigung, da die Ausnehmungen in einem Stanzprozess eingebracht sind. Zudem muss ein ebenes Stahlblech nach dem Stanzvorgang in eine zylindrische Form gebracht und an seiner Stoßkante verschweißt werden.

Ein Ziel der Erfindung besteht darin, ein Verfahren zur Herstellung eines Vorspannelements für ein Aktorelement einer Aktoreinheit zur Verfügung zu stellen, das eine hohe Elastizität aufweist.

Dieses Ziel der Erfindung wird mit dem Gegenstand des unabhängigen Patentanspruches erreicht. Merkmale vorteilhafter Weiterbildungen der Erfindung ergeben sich aus den abhängigen Ansprüchen.

Dem gemäß wird bei einem Verfahren zur Herstellung einer Rohrfeder in Form eines Hohlkörpers, insbesondere zur Vorspannung eines piezoelektrischen Aktorelements einer Aktoreinheit eines Kraftstoffinjektors ein dünnwandiges Metallrohr mittels Strahlschneiden mit einer Vielzahl von regelmäßig angeordneten, länglichen Ausnehmungen versehen.

Durch die Ausnehmungen, die länglich ausgeformt sind, ist gewährleistet, dass der Hohlkörper auch bei den üblicherweise angelegten Vorspannungen auf den piezoelektrischen Aktor von ca. 800 N bis 1000 N eine ausreichende Festigkeit zeigt und gleichzeitig genügend elastisch zum Ausführen der von dem piezoelektrischen Aktor erzeugten Längsbewegungen ist. Mittels des Strahlschneidens ist es möglich, sehr schmale und kleine Ausnehmungen in den zylindrischen Hohlkörper einzu-bringen, wie sie mittels eines Stanzvorgangs nicht in dieser Form eingebracht werden könnten. Es können somit auf gleicher Fläche wesentlich mehr Ausnehmungen untergebracht werden, was zu einer signifikanten Absenkung der Federrate der strahlgeschnittenen Variante der Rohrfeder führt. Dagegen sind typische Abmessungen von gestanzten Ausnehmungen aufgrund der erforderlichen Mindestabmessungen des Stanzstempels und der damit verbundenen Stanzzeit des Stanzwerkzeugs in relativ engen Grenzen vorgegeben. Somit ist bei gestanzten Ausnehmungen auch die Anzahl der Ausnehmungen je Flächeneinheit begrenzt, was zu einer relativ hohen Federrate führt.

Aufgrund der relativ geringen Federsteifigkeit der strahlgeschnittenen Rohrfeder geht ein nur sehr geringer Teil der vom Aktor ausgeführten Bewegungsenergie durch die Federsteifigkeit des Vorspannelements als Nutzhub verloren.

Der Hohlkörper kann vorzugsweise eine zylindrische Kontur aufweisen. Als Material für den Hohlkörper kommt insbesondere ein dünnwandiges, nahtlos gezogenes Stahlrohr in Frage.

Als Strahlschneidverfahren eignet sich bspw. Laserstrahlschneiden, Wasserstrahlschneiden oder Elektronenstrahlschneiden. Alle diese Strahlschneidverfahren lassen sich mit hoher Präzision durchführen und führen zu sehr exakten und maßhaltigen Werkstücken.

Eine erste Ausführungsform des erfindungsgemäßen Verfahrens sieht vor, dass durch den Einsatz eines geeigneten Füllkörpers im Inneren des Hohlzylinders während des Strahlschneidens eine definierte Formgebung der Strahlaustrittskante erreicht und eine Beschädigung der Gegenseite verhindert wird.

Eine weitere bevorzugte Variante des erfindungsgemäßen Verfahrens sieht vor, dass eine Längserstreckungsrichtung jeder Ausnehmung jeweils im wesentlichen senkrecht zur Zylindermittelachse der Rohrfeder ausgerichtet ist. Auf diese Weise kann der Rohrfeder in Richtung ihrer Längsachse eine gewünschte Federsteifigkeit aufgeprägt werden. Gemäß einer weiteren Ausführungsform des erfindungsgemäßen Verfahrens sind die Ausnehmungen in Reihen angeordnet, wobei die Ausnehmungen benachbarter Reihen jeweils gegeneinander seitlich versetzt angeordnet sind. Diese Gestaltung weist den Vorteil eines idealen Federungsverhaltens der Rohrfeder auf, da die abwechselnd aufeinandertreffende Stege und Ausnehmungen zu einer möglichen Eindrückung der Ausnehmungen führen können, wobei die dazwischenliegenden Stege jeweils ihre Form beibehalten können.

Gemäß einer weiteren erfindungsgemäßen Variante beträgt ein minimaler Abstand zwischen benachbarter Ausnehmungen zweier Reihen das 0,3- bis 4-fache der Wandstärke des zylindrischen Hohlkörpers der Rohrfeder. Je nach gewählten Abmessungen der Ausnehmungen sowie der Wandstärke der Rohrfeder kann eine ideale Federkonstante gewählt werden.

Die Ausgestaltung der Rohrfeder bietet die Möglichkeit, zwischen einer relativ großen Anzahl von möglichen Werkstoffen auszuwählen, da bei gleichbleibender Federrate eine Absenkung der Spannungen möglich ist. So können beispielsweise Werkstoffe gewählt werden, die zwar eine niedrige Festigkeit aufweisen, die aber für später folgende Schweißprozesse eine bestmögliche Werkstoffpaarung darstellen. Weiterhin können auch Werkstoffe gewählt werden, die optimal für den Strahlschneidvorgang bzw. den Laserschneidprozess geeignet sind, d.h. solche mit einem relativ niedrigen Schwefelgehalt von weniger als 0,25%.

Das für die Rohrfeder verwendete nahtlos gezogene Metallrohr weist vorzugsweise eine Stärke von weniger als 1,0 mm auf. Wahlweise kann die Stärke jedoch auch größer gewählt werden, um auf diese Weise auch bei einem verwendeten Stahl von geringerer Festigkeit zu einer gewünschten Federsteifigkeit zu gelangen.

Vorzugsweise ist das für die Rohrfeder verwendete nahtlos gezogene Metallrohr ein Federstahl, da ein solcher relativ günstige elastische Eigenschaften auch bei sehr kleinen Abmessungen aufweist.

Gemäß einer Variante des erfindungsgemäßen Verfahrens können die Ausnehmungen jeweils eine hantelförmige Kontur mit eingeschnürtem Mittelbereich aufweisen, wodurch wiederum eine gezielte Beeinflussung der gewünschten Federsteifigkeit realisierbar ist.

Zusammenfassend ergeben sich die folgenden Vorteile des erfindungsgemäßen Verfahrens. Durch den Einsatz eines Strahlschneideverfahrens wird eine hohe Genauigkeit der Aussparungen der Rohrfeder erreicht. Es sind über das Strahlschneiden hinaus keine zusätzlichen Bearbeitungsschritte erforderlich. Zudem kann damit eine hohe Oberflächengüte in den Ausnehmungen erzielt werden, wie sie mittels eines Stanzvorganges nicht erreichbar wäre.

Die Verwendung von nahtlos gezogenen Stahlrohren ermöglicht eine verbesserte Maßhaltigkeit der gewünschten Zylinderkontur der Rohrfeder. Aufgrund des Verzichts auf eine Längsschweißnaht, wie sie bei bekannten Verfahren notwendig ist, ergeben sich weniger potentielle Fehlstellen im Metall. Zudem kann auf die üblicherweise notwendige Nahtbearbeitung verzichtet werden.

Eine Aktoreinheit weist einen dünnwandigen zylindrischen Hohlkörper auf, der um ein piezoelektrisches Aktorelement angeordnet ist, wobei der Hohlkörper elastisch ausgebildet ist und das Aktorelement vorspannt und wobei der Hohlkörper ein mit einer Vielzahl von länglichen Ausnehmungen versehenes Metallrohr, insbesondere ein nahtlos gezogenes Stahlrohr ist. Eine Aktoreinheit mit einem derartigen zylindrischen Hohlkörper als Rohrfeder kann mit sehr exakt gewählten Eigenschaften der Rohrfeder versehen werden.

Die Erfindung wird nun anhand von Ausführungsformen mit Bezug auf die beiliegenden Figuren näher erläutert. Es zeigen:
- Figur 1: eine Aktoreinheit in schematischer Querschnittdarstellung,
- Figur 2: eine Rohrfeder in schematischer Seitenansicht, die mittels des erfindungsgemäßen Verfahrens hergestellt ist,
- Figur 3: eine Detailansicht einer ersten Ausführungsform der Rohrfeder gemäß Figur 2 und
- Figur 4: eine Detailansicht einer alternativen Ausführungsform der Rohrfeder.

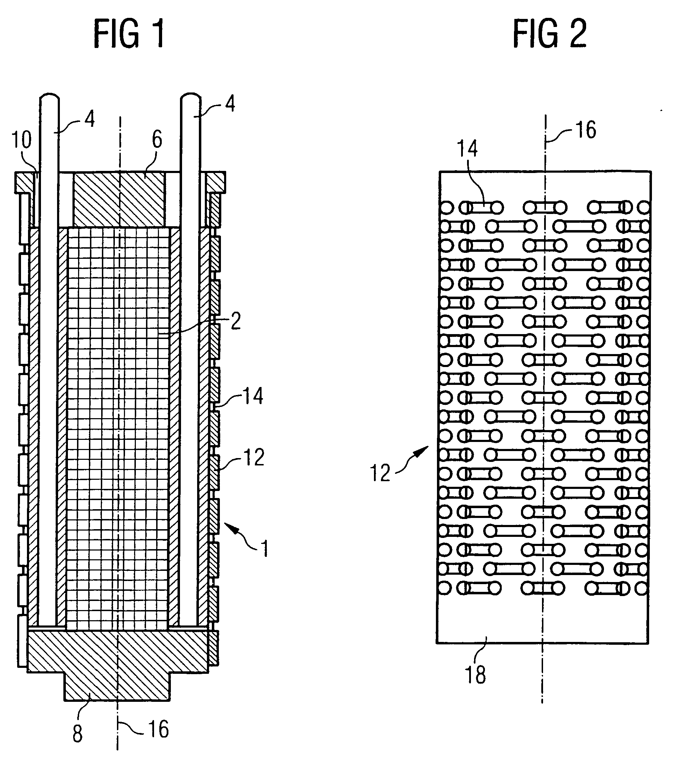

Figur 1 zeigt eine Aktoreinheit 1, bestehend aus mehreren gestapelten, piezoelektrischen Einzelelementen. Die piezoelektrische Aktoreinheit 1 wird mittels Kontaktstiften 4 mit elektrischer_Spannung beaufschlagt. Die Kontaktstifte 4 sind jeweils längs der Aktoreinheit 1 angeordnet und stehen mit dem Aktorelement 2 in elektrisch leitender Verbindung. Durch Anlegen einer Spannung zwischen den Kontaktstiften 4 wird eine Längsdehnung des piezoelektrischen Aktorelements 2 erzeugt, die beispielsweise zum Stellen eines Einspritzventils einer Brennkraftmaschine eingesetzt werden kann. Das piezoelektrische Aktorelement 2 mit den Kontaktstiften 4 ist in einem als Rohrfeder 12 ausgebildeten zylindrischen Hohlkörper angeordnet.

Das piezoelektrische Aktorelement 2 liegt mit seinen Stirnflächen jeweils an einer Abdeckplatte 6 bzw. Bodenplatte 8 an, wobei die obere Abdeckplatte 6 Durchführungen 10 aufweist, durch die sich die Kontaktstifte 4 erstrecken. Die Abdeckplatte 6 und die Bodenplatte 8 sind jeweils form- und/oder kraftschlüssig, vorzugsweise durch Anschweißen, mit der Rohrfeder 12 verbunden. Alternativ kann die Verbindung zwischen der Rohrfeder 12 und den beiden Platten 6, 8 auch mit Hilfe einer Bördelung erfolgen, wobei die umgebördelten oberen und unteren Randbereiche des Hohlkörpers jeweils in der Abdeck- 6 bzw. Bodenplatte 8 eingreifen. Das piezoelektrische Aktorelement 2 ist durch die beiden Platten 6, 8, die von der Rohrfeder 12 in Position gehalten werden, mit einer definierten Kraft von vorzugsweise 800 N bis 1000 N vorgespannt. Um diese Vorspannung aufrechterhalten zu können, wird der das piezoelektrische Aktorelement 2 aufnehmende Hohlkörper vorzugsweise aus Federstahl gefertigt, da Federstahl sich durch einen hohen Festigkeitskennwert auszeichnet. Alternativ können jedoch auch andere Materialien, beispielsweise Werkstoffe mit niedrigem Elastizitätsmodul, wie zum Beispiel Kupfer-Beryllium-Legierungen, eingesetzt werden.

Figur 2 zeigt die Rohrfeder 12 in Seitenansicht. Die Rohrfeder 12 ist ein zylindrischer Hohlkörper, der aus einem Metallrohr gefertigt ist. In eine Mantelfläche 18 der Rohrfeder 12 sind eine Vielzahl von Ausnehmungen 14 eingebracht, die mittels Laserschneiden hergestellt sind. Die länglichen Ausnehmungen sind jeweils im wesentlichen senkrecht zur Mittelachse 16 der Rohrfeder 12 orientiert. Die Ausnehmungen 14 sind jeweils in Reihen angeordnet, wobei die Ausnehmungen 14 benachbarter Reihen jeweils gegeneinander seitlich versetzt angeordnet sind. Der minimale Abstand zwischen benachbarter Ausnehmungen 14 zweier benachbarter Reihen kann das 0,3- bis 4-fache der Wandstärke der Rohrfeder betragen.

Als Metallrohr kommt insbesondere ein nahtlos gezogenes Stahlrohr, bspw. aus Federstahl, in Frage.

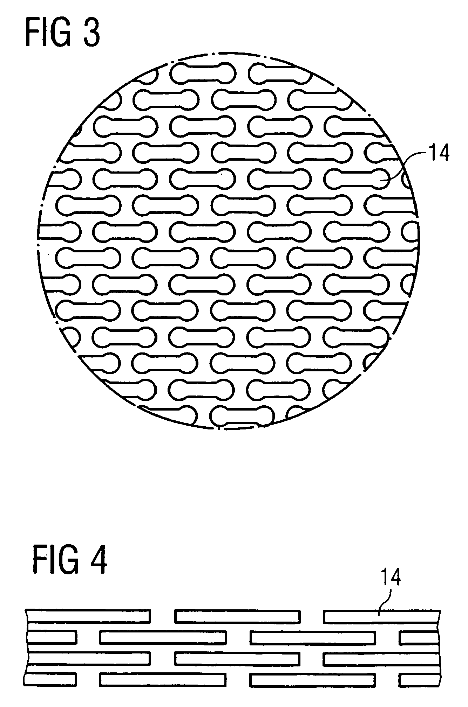

Figur 3 zeigt eine Detailansicht der mit Ausnehmungen 14 versehenen Mantelfläche 18 der Rohrfeder 12 gemäß Figur 2. Hierbei sind die Ausnehmungen 14 jeweils keulenartig ausgebildet, so dass sie in einem mittleren Bereich jeweils eine Einschnürung aufweisen. Diese Gestaltung wirkt sich günstig auf die Materialbelastung aus und ermöglicht damit geringe Federsteifigkeiten der gesamten Rohrfeder 12.

Wahlweise können die Ausnehmungen 14 in Form von regelmäßigen Langlöchern bzw. schmalen Rechtecken ausgebildet sein, wie dies in Figur 4 beispielhaft dargestellt ist. Als Konturen für die Ausnehmungen 14 kommen annähernd beliebige Formen in Frage, welche zu einer geringeren Federrate in axialer Richtung der Rohrfeder führen. So können die Ausnehmungen bspw. auch als längliche Ausnehmungen mit halbrundförmigen Enden ausgestaltet sein.

Die Rohrfeder kann beispielsweise aus einem nahtlos gezogenen Stahlrohr mit einer Dicke von 1,0 mm oder weniger gefertigt sein. Ein Stahlrohr mit einer Dicke von mehr als 1,0 mm eignet sich insbesondere dann, wenn ein Stahl geringerer Festigkeit verwendet wird.

Um die Festigkeit der Rohrfeder nach dem Laserschneidvorgang weiter zu steigern, kann eine Wärmebehandlung durchgeführt werden. Alternativ zu den in Figur 2 gezeigten geradlinigen Stoßkanten der Rohrfeder 12 können beliebige andere Stoßkantenformen, beispielsweise in Form einer Sinuswelle oder einer Zickzacklinie ausgebildet sein, wobei zum Fixieren der Rohrfeder dann eine entsprechend geformte Schweißnaht bzw. eine Punktschweißung verwendet wird.

Statt einer Fixierung der Rohrfeder 12 durch Schweißen kann eine Fixierung auch durch die oberen und unteren Platten 6, 8 erfolgen, so dass die Stoßkanten nur aneinander anliegen. Hierdurch kann sich eine vorteilhafte Verteilung der Druck- und Federkräfte im Hohlkörper ergeben.

Eine Ausbildung der Aktoreinheit mit einem äußeren Hohlkörper, der vorzugsweise als Rohrfeder ausgebildet ist und in dem der piezoelektrische Aktor mittels form- und/oder kraftschlüssig mit dem Hohlkörper verbundenen oberen und unteren Abdeckungen vorgespannt ist, ermöglicht aufgrund seines kompakten Aufbaus einen einfachen Transport und einen leichten Ein- und Ausbau, zum Beispiel in ein Einspritzventil einer Brennkraftmaschine.

## Patentansprüche

1. Verfahren zur Herstellung einer Rohrfeder (12) in Form eines Hohlkörpers, insbesondere zur Vorspannung eines piezoelektrischen Aktorelements (2) einer Aktoreinheit (1) eines Kraftstoffinjektors, **dadurch gekennzeichnet, dass** ein Rohr, insbesondere ein dünnwandiges nahtlos gezogenes Stahlrohr, mittels Strahlschneiden mit einer Vielzahl von regelmäßig angeordneten länglichen Ausnehmungen (14) versehen wird.

2. Verfahren nach Anspruch 1,
**dadurch gekennzeichnet, dass**
als Strahlschneidverfahren insbesondere Laser-, Wasserstrahl oder Elektronenstrahlschneiden eingesetzt wird.

3. Verfahren nach Anspruch 1 oder 2,
**dadurch gekennzeichnet, dass**
während des Strahlschneiden ein Füllkörpers innerhalb des Hohlkörpers eingefügt wird.

4. Verfahren nach einem der Ansprüche 1 bis 3,
**dadurch gekennzeichnet, dass**
eine Längserstreckungsrichtung jeder Ausnehmung (14) jeweils im Wesentlichen senkrecht zur Zylindermittelachse (16) der Rohrfeder (12) ausgerichtet wird.

5. Verfahren nach einem der Ansprüche 1 bis 4,
**dadurch gekennzeichnet, dass**
die Ausnehmungen (14) in Reihen angeordnet werden, wobei die Ausnehmungen (14) benachbarter Reihen jeweils gegeneinander seitlich versetzt angeordnet sind.

6. Verfahren nach einem der Ansprüche 1 bis 5,
**dadurch gekennzeichnet, dass**
ein minimaler Abstand zwischen benachbarten Ausnehmungen (14) zweier Reihen das 0,3- bis vierfache der Wandstärke des zylindrischen Hohlkörpers der Rohrfeder (12) beträgt.

7. Verfahren nach einem der vorstehenden Ansprüche,
**dadurch gekennzeichnet, dass**
das für die Rohrfeder (12) verwendete nahtlos gezogene Stahlrohr eine Stärke von weniger als 1,0 Millimetern aufweist.

8. Verfahren nach einem der vorstehenden Ansprüche,
**dadurch gekennzeichnet, dass**
als Werkstoff des für die Rohrfeder (12) verwendeten nahtlos gezogenen Stahlrohres ein Federstahl verwendet wird.

9. Verfahren nach einem der vorstehenden Ansprüche,
**dadurch gekennzeichnet, dass**
die Rohrfeder (12) mit Ausnehmungen (14) versehen wird, die insbesondere hantelförmige Konturen mit eingeschnürtem Mittelbereich aufweisen.

## Claims

1. Method for producing a tubular spring (12) in the form of a hollow body, more specifically for preloading a piezoelectric actuator element (2) of an actuator unit (1) of a fuel injector, **characterised in that** a tube, more specifically a thin-walled seamless drawn steel tube, is provided with a plurality of regularly disposed oblong cutouts (14) by means of beam/jet cutting.

2. Method according to claim 1, **characterised in that** more specifically laser beam, waterjet or electron beam cutting are used as the beam/jet cutting method.

3. Method according to claim 1 or 2, **characterised in that** during beam/jet cutting a filler is inserted in the hollow body.

4. Method according to one of claims 1 to 3, **characterised in that** a longitudinal extension direction of each cutout (14) is in each case essentially oriented perpendicularly to the cylinder centre line (16) of the tubular spring (12) .

5. Method according to one of claims 1 to 4, **characterised in that** the cutouts (14) are disposed in rows, the cutouts (14) of adjacent rows each being laterally offset to one another.

6. Method according to one of claims 1 to 5, **characterised in that** a minimum distance between adjacent cutouts (14) of two rows is 0.3 to four times the wall thickness of the cylindrical hollow body of the tubular spring (12).

7. Method according to one of the preceding claims, **characterised in that** the seamless drawn steel tube used for the tubular spring (12) has a thickness of less than 1.0 millimetres.

8. Method according to one of the preceding claims, **characterised in that** a spring steel is used as the material of the seamless drawn steel tube used for the tubular spring (12).

9. Method according to one of the preceding claims, **characterised in that** the tubular spring (12) is provided with cutouts (14) which more specifically have shaped-shaped outlines with a narrowed-down central area.

## Revendications

1. Procédé de fabrication d'un ressort tubulaire (12) sous la forme d'un corps creux, en particulier, pour mettre en précontrainte un élément actionneur piézoélectrique (2) d'une unité d'actionneur (1) d'un injecteur de carburant,
**caractérisé en ce que**
un tube, en particulier un tube d'acier à paroi mince, étiré sans soudure, est muni, au moyen d'un découpage par rayonnement, d'une multiplicité d'évidements (14) allongés, disposés régulièrement.

2. Procédé suivant la revendication 1,
**caractérisé en ce que**,comme procédé de découpage par rayonnement, on utilise, en particulier, un découpage par rayonnement laser, par jet d'eau, ou par rayonnement électronique.

3. Procédé suivant la revendication 1 ou 2,
**caractérisé en ce que**,pendant le découpage par rayonnement, un corps de remplissage est introduit à l'intérieur du corps creux.

4. Procédé suivant l'une des revendications 1 à 3,
**caractérisé en ce qu'**une direction d'extension longitudinale de chaque évidement (14) est chaque fois essentiellement dirigée perpendiculairement à l'axe central (16) du cylindre du ressort tubulaire (12)

5. Procédé suivant l'une des revendications 1 à 4,
**caractérisé en ce que** les évidements (14) sont disposés suivant des rangées, les évidements (14) appartenant à des rangées voisines étant disposés chaque fois décalés latéralement les uns par rapport aux autres.

6. Procédé suivant l'une des revendications 1 à 5,
**caractérisé en ce qu'**une distance minimale entre des évidements (14) voisins appartenant à deux rangées est égale à 0,3 à quatre fois l'épaisseur de paroi du corps creux cylindrique du ressort tubulaire (12).

7. Procédé suivant l'une des revendications précédentes,
**caractérisé en ce que** le tube d'acier étiré sans soudure, utilisé pour le ressort tubulaire (12), présente une épaisseur de moins de 1,0 millimètre.

8. Procédé suivant l'une des revendications précédentes,
**caractérisé en ce qu'**un acier à ressort est utilisé comme matériau du tube d'acier étiré sans soudure, utilisé pour le ressort tubulaire (12),

9. Procédé suivant l'une des revendications précédentes,
**caractérisé en ce que** le ressort tubulaire (12) est muni d'évidements (14) qui présentent, en particulier, des contours en forme d'haltère comportant une zone centrale rétrécie.
